# EUROPÄISCHE PATENTSCHRIFT

(11) **EP 2 438 450 B1**
(45) Veröffentlichungstag und Bekanntmachung des Hinweises auf die Patenterteilung: **11.12.2013**
(21) Anmeldenummer: 10716484.0
(22) Anmeldetag: 21.04.2010
(51) Int. Cl.: G01R 31/12, H02M 1/12

(54) **VORRICHTUNG ZUR PRÜFUNG VON GERÄTEN DER HOCHSPANNUNGSTECHNIK**
DEVICE FOR TESTING HIGH-VOLTAGE EQUIPMENT
DISPOSITIF PERMETTANT DE VÉRIFIER DES APPAREILS DE LA TECHNIQUE DE HAUTE TENSION

(30) Priorität: 03.06.2009 DE 102009023713
(43) Veröffentlichungstag der Anmeldung: 11.04.2012
(73) Patentinhaber: Maschinenfabrik Reinhausen GmbH, 93059 Regensburg (DE); PCS Power Control Solutions Verwaltungs AG, 82031 Grünwald (DE)
(72) Erfinder: ANNOWSKY, Rene, 15344 Straussberg (DE); THIEDE, Andreas, 01465 Schönborn (DE)
(86) Internationale Anmeldenummer: PCT/EP2010/002426
(87) Internationale Veröffentlichungsnummer: WO 2010/139382

(56) Entgegenhaltungen:
- EP-A1- 1 318 594
- EP-A2- 0 682 395
- WO-A1-02/15376
- WO-A1-2009/071266
- WINTER A ET AL: "A mobile transformer test system based on a stativ frequency converter" XV INTERNATIONAL SYMPOSIUM ON HIGH VOLTAGE ENGINEERING, UNIVERSITY OF LJUBLJANA, ELEKTROINSITUT MILAN VIDMAR, LJUBLANA, SLOVENIA, AUGUST 27-31, 2007,, [Online] 4. September 2007 (2007-09-04), Seiten 1-6, XP002500564 Gefunden im Internet: URL:http://www.ish2007.org/pdf/aWinter.pdf > [gefunden am 2008-10-20]
- WINTER A ET AL: "A New Generation of On-Site Test Systems for Power Transformers" 2008 IEEE INTERNATIONAL SYMPOSIUM ON ELECTRICAL INSULATION; 9-12 JUNE 2008; VANCOUVER, BC, CANADA, IEEE, 10. Juni 2008 (2008-06-10), Seiten 478-482, XP007906016 ISBN: 978-1-4244-2092-6

## Beschreibung

Die vorliegende Erfindung betrifft eine Vorrichtung zur Prüfung von Geräten der Hochspannungstechnik, insbesondere von Leistungstransformatoren oder Drosseln.

Es hat sich in diesem Zusammenhang als vorteilhaft erwiesen, bei Vorrichtungen zur Prüfung von Geräten der Hochspannungstechnik, statt rotierenden Umformern statische Frequenzumrichter einzusetzen, da diese gegenüber den rotierenden Umformern klare Vorteile in Bezug auf Dynamik, Verschleiß, Gewicht und Verfügbarkeit besitzen. Derartige Prüfvorrichtungen mit statischen Frequenzumrichtern werden beispielsweise offenbart in "A Mobile Transformer Test System Based on a Static Frequency Converter", A. Winter et al. (XVth International Symposium on High Voltage Engineering, University of Ljubljana, Elektroinstitut Milan Vidmar, Ljubljana, Slovenia, August 27-31, 2007) und in "A New Generation of On-Site Test Systems for Power Transformers", Alexander Winter et al (2008 IEEE International Symposium on Electrical Insulation, 9-12 June 2008, Vancouver, BC, Canada, Pages 478-482). Die Frequenzumrichter müssen dabei eine sinusförmige, symmetrische Wechselspannung erzeugen, die zudem einen Klirrfaktor von kleiner als 5% besitzt. Zur Überprüfung der Isolationssysteme der Leistungstransformatoren dient die induzierte Spannungsprüfung, bei der Teilentladungsmessungen durchgeführt werden. Treten in Hochspannungsisolierungen oder entlang von Luftstrecken stark inhomogene Feldverläufe auf, kann es zu einer örtlichen Überschreitung der materialtypischen Durchschlagfeldstärke kommen. In diesem Zustand eines unvollkommenen elektrischen Durchschlages wird die Isolierung zwischen den Elektroden durch Entladungen nur teilweise überbrückt. Solche Teilentladungen treten vor allem bei Beanspruchung der Isolierung mit Wechselspannung auf. Für eine erfolgreiche Teilentladungsmessung dürfen die äußeren einwirkenden Störgrößen allerdings einen Teilentladungs-Grundstörpegel von 100pC nicht überschreiten. Um dies zu gewährleisten, werden die jeweiligen Ausgänge des Frequenzumrichters einem Sinusfilter zugeführt, der als Tiefpassfilter wirkt.

Prinzip bedingt erzeugt ein statischer Frequenzumrichter jedoch eine Pulsweiten modulierte, rechteckförmige Ausgangsspannung mit großem Klirrfaktor, die sich in dieser Form zunächst nicht zur Prüfung von Leistungstransformatoren eignet. Ein am Ausgang des statischen Frequenzumrichters angeordnetes Sinusfilter ermöglicht die Filterung der Grundschwingung zwischen den Außenleitern des Wechselrichterausgangs und damit die Unterdrückung der vom Wechselrichter erzeugten symmetrischen Störgrößen. Trotz des zusätzlich vorgesehenen Sinusfilters lassen sich pulsfrequente Sprünge der Leiter-Erde-Spannung am Wechselrichterausgang nicht unterdrücken. Diese unerwünschten asymmetrischen Störgrößen werden über verschiedene elektrische Koppelmechanismen weit bis in den zu prüfenden Transformator geleitet und führen dort zu erheblichen Störungen der angestrebten Teilentladungsmessung.

Aus der nicht vorveröffentlichten Anmeldung DE 10 2007 059 289.4-35 der Anmelderin ist eine gattungsgemäße Prüfvorrichtung bekannt geworden, die das Problem der asymmetrischen Störgrößen unterdrückt, indem sie einen statischen Frequenzumrichter vorsieht, der mehrere Ausgänge besitzt, die mit einer Filtereinrichtung verbunden sind und wobei die Ausgänge der Filtereinrichtung ihrerseits mit einem Anpassungstransformtor verbunden sind, der seinerseits wiederum an dem für die eigentliche Prüfung vorgesehenen Prüfobjekt, insbesondere einem Transformator, angeschlossen ist. In dieser Anmeldung wird vorgeschlagen, als Filtereinrichtung einen Filtertransformator vorzusehen, der zwischen seiner Primär- und Sekundärseite einen elektrostatischen Schirm aufweist, bei dem an jedem Ausgang der Sekundärseite ein Filterkondensator abgezweigt ist und zudem die Filterkondensatoren untereinander in einer Sternschaltung mit einem geerdeten Sternpunkt geschaltet sind. Diese Anordnung zur Teilentladungsmessung ist in der DE 10 2007 059 289.4-35 möglich, da der vorgesehene Filterkondensator eine lastseitige Potenzialtrennung zwischen dem Frequenzumrichter und den verbauten Filterkondensatoren bewirkt. Bei herkömmlichen, nur aus Längsdrosseln und Kondensatoren aufgebauten Sinusfiltern können die Filterkondensatoren nicht in dieser Weise angeordnet werden, da ansonsten ein kapazitiver Erdschluss der Wechselrichterphasen entstehen würde.

Wie aus der Firmendruckschrift 8.71/3 ersichtlich, gibt es jedoch seit einiger Zeit Bestrebungen, dem Kunden mobile Transformatorenprüfsysteme anzubieten, um damit eine "Vor-Ort-Prüfung" von Hochleistungstransformatoren zu ermöglichen. Diese mobilen Prüfsysteme werden als vorkonfigurierte Anlagen in einem Container installiert und mit einer Transportlafette zum Ort der Prüfung bzw. dem Standort des Testobjektes gefahren. Vor Ort ist die Herstellung der letztlich benötigten Prüfschaltung in nur wenigen Schritten möglich. Der Kundennutzen liegt in der mobilen Verfügbarkeit eines einzigen Prüfsystems für die Prüfung einer Vielzahl verschiedenerorts fest installierter Hochleistungstransformatoren. Die Installationszeit- und Betriebskostenersparnis eines derartigen mobilen Prüfsystems gegenüber herkömmlichen stationären Prüfanlagen ist hoch. Dem entsprechend groß ist die Nachfrage nach mobilen Prüfsystemen, die hinsichtlich der Bandbreite ihrer Prüfleistungen immer variabler und stärker dimensionierbar sind. Die prüfleistungsmäßige Dimensionierung steht jedoch in direktem Zusammenhang mit der Gesamtmasse des mobilen Prüfsystems. Da dieses, wie bereits erwähnt, in einem Container verbaut wird, unterliegt die Gesamtmasse der in Deutschland geltenden Straßenverkehrs-Zulassungs-Ordnung und damit gesetzlichen Beschränkungen, sowohl im Hinblick auf die zulässige Gesamtmasse, als auch der Achslastverteilung. Im internationalen Umfeld gibt es gleich gelagerte Restriktionen mit nahezu identischen Grenzwerten. Das aus der Firmendruckschrift 8.71/3 bekannt gewordene mobile Prüfsystem reizt dabei die Grenzen der rechtlich zulässigen Gesamtmassen und Achslastverteilungen weitestgehend aus. Der in diesem Modell verbaute Filtertransformator zur Unterdrückung asymmetrischer Störgrößen hat eine Leistung von 500 kVA. Eine nennenswerte Erhöhung der Prüfleistung kann mit einem derartigen Prüfsystem nicht mehr erzielt werden.

Daher ist es Aufgabe der vorliegenden Erfindung, eine Vorrichtung zur Prüfung von Geräten der Hochspannungstechnik, insbesondere von Leistungstransformatoren oder Drosseln anzugeben, die hinsichtlich ihrer erzielbaren Prüfleistung eine deutliche Erhöhung gegenüber dem Stand der Technik bietet und trotzdem als mobiles Transformatorenprüfsystem einsetzbar ist.

Diese Aufgabe wird durch eine Vorrichtung zur Prüfung von Geräten der Hochspannungstechnik mit den Merkmalen des ersten Patentanspruches gelöst. Die Unteransprüche betreffen besonders vorteilhafte Weiterbildungen der Erfindung.

Die allgemeine erfinderische Idee besteht darin, die erforderliche Potenzialtrennung zur Unterdrückung asymmetrischer Störgrößen auf die Eingangsseite des statischen Frequenzumrichters, also auf die Netzstromseite, zu verschieben. Die bisher lastseitige Potenzialtrennung durch den im Sinusfilter verbauten Filtertransformator erfordert verhältnismäßig groß dimensionierte Transformatoren. Dies liegt darin begründet, dass der netzseitige Teil des statischen Frequenzumrichters nur für die Bereitstellung der Wirkleistung des Prüfsystems verantwortlich ist. Der lastseitige Teil des statischen Frequenzumrichters muss darüber hinaus in der Lage sein, eine zur Prüfung benötigte hohe Blindleistung bereit zu stellen. Daher ist der lastseitige Teil des statischen Frequenzumrichters i.d. R. leistungsstärker dimensioniert als der netzseitige (typ.: netzseitig 40 % Leistung, lastseitig: 100 % Leistung). Bei einer signifikanten Erhöhung der lastseitigen Scheinleistung müsste daher ein entsprechend großer Filtertransformator eingesetzt werden. Das Prüfsystem wäre dann nicht mehr verkehrstauglich hinsichtlich der in der Straßenverkehrs-Zulassungs-Ordnung reglementierten zulässigen Gesamtmassen und Achslastverteilungen. Indem nun die Potenzialtrennung erfindungsgemäß auf die Netzseite des statischen Frequenzumrichters verlagert wird, ist ein in seiner Wirkung gleichwertiges mobiles Prüfsystem mit einem Transformator ,der nur entsprechend der netzseitigen Wirkleistung dimensioniert sein muss, ausreichend. Damit kann mit dieser Maßnahme die Konformität der zulässigen Gesamtmasse und Achslastverteilung auf besonders einfache und effektive Weise gewährleistet werden.

Die eigentliche Filtereinrichtung beseht also nicht mehr, wie aus der DE 10 2007 059 289.4-35 bekannt, aus einem Filtertransformator und untereinander in einer Sternschaltung verschalteten geerdeten Filterkondensatoren, sondern aus nur mehr an den Ausgängen des statischen Frequenzumrichters in Reihe angeschlossenen Drosseln und danach in einer Sternschaltung verschaltete geerdete Filterkondensatoren, die eine Filterung der asymmetrischen Störgrößen zwischen den Außenleitern und Erde bewirken. Ermöglicht wird diese Filterung der asymmetrischen Störgrößen erst auf Grund der Potenzialtrennung des netzseitig eingesetzten Transformators. Dabei ist zwischen der Primär- und Sekundärseite des netzseitig eingesetzten Transformators ein geerdeter elektrostatischer Schirm vorgesehen, der zusätzlich zur Ableitung der asymmetrischen Störgrößen beiträgt.

Es ist vorteilhaft, wenn der statische Frequenzumrichter, der netzseitige Transformator und das lastseitige Sinusfilter mit den in Sternschaltung verschalteten Filterkondensatoren in einem Schaltschrank untergebracht sind, so dass keine asymmetrischen Störungen zu dem der Prüfung unterzogenen Transformator gelangen.

Nach einer bevorzugten Ausführungsform sind in der Filtereinrichtung neben den sternförmig geschalteten Filterkondensatoren weitere in Dreieckschaltung zueinander verschaltete Kondensatoren vorgesehen, die eine Filterung der symmetrischen Störgrößen zwischen den Außenleitern bewirken.

Indem erfindungsgemäß der Transformator für das Prüfsystem auf die Netzseite verlagert wird, weist die gesamte Anlage eine deutlich gegenüber dem Stand der Technik reduzierte Gesamtmasse auf. Außerdem kann bei dem neuen Prüfsystem auch die passive Kompensationseinheit entfallen, was zusätzlich zur Massenreduzierung mit beiträgt.

Die vorliegende Erfindung ist jedoch nicht nur auf mobile Transformatorenprüfsysteme beschränkt. Vielmehr ist es auch denkbar, die allgemeine erfinderische Idee, nämlich die Verlagerung des Transformators auf die speisende Netzseite, auch auf eine stationäre Transformatorenprüfvorrichtung anzuwenden.

Die Erfindung soll nachstehend an Hand von Zeichnungen beispielhaft noch näher erläutert werden. Es zeigen
- Figur 1: einen aus dem Stand der Technik nicht vorveröffentlichten Schaltplan eines Transformatorenprüfsystems
- Figur 2: einen Schaltplan einer erfindungsgemäßen Vorrichtung
- Figur 3: eine bevorzugte Ausführungsform der Erfindung mit zusätzlichen Filterkondensatoren.

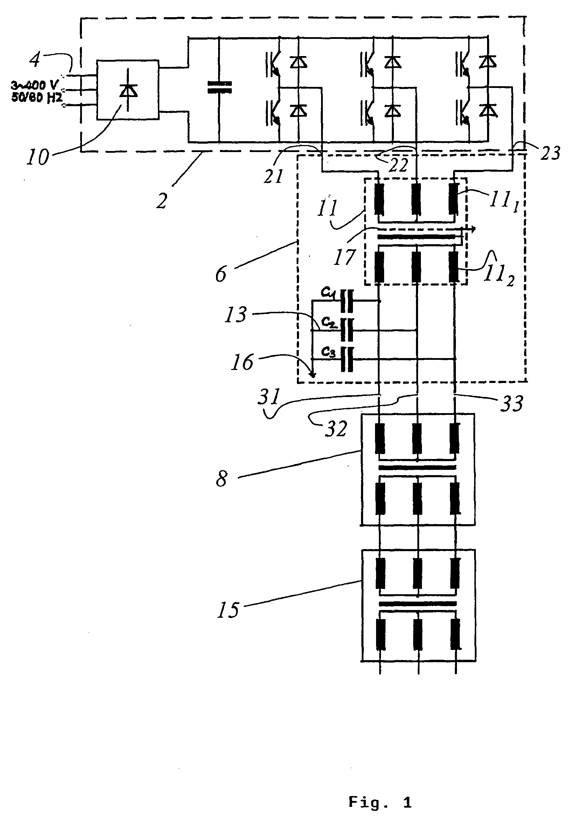

In Figur 1 ist ein in der DE 10 2007 059 289.4-35 beschriebener, jedoch nicht vorveröffentlichter Schaltplan einer Vorrichtung zur Prüfung von Geräten der Hochspannungstechnik gezeigt. Dabei wird ein statischer Frequenzumrichter 2 mit Wechselspannung aus dem Stromnetz 4 versorgt, die zunächst auf einen Gleichrichter 10 gelangt. Zudem weist der Frequenzumrichter 2 einen ersten Ausgang 21, einen zweiten Ausgang 22 und einen dritten Ausgang 23 auf. Der statische Frequenzumrichter 2 ist ein Spannungszwischenkreis-Umrichter mit einer digitalen Steuerung und Regelung. Die jeweiligen Ausgänge 21, 22 und 23 des statischen Frequenzumrichters 2 werden einer Filtereinrichtung 6, insbesondere einer Primärseite 11/1 eines Filtertransformators 11, zugeführt. Der Filtertransformator 11 umfasst die Primärseite 11/1 und eine Sekundärseite 11/2. Die Sekundärseite 11/2 des Filtertransformators 11 ist mit Filterkondensatoren C1, C2 und C3 verbunden, die in einer Sternschaltung 13 angeordnet sind. Der durch die Sternschaltung entstehenden Sternpunkt ist seinerseits wiederum mit der Erde 16 verbunden. Der Filtertransformator 11 stellt eine Potenzialtrennung zwischen den jeweiligen Ausgängen 21 bis 23 des Frequenzumrichters und den Kondensatoren C1 bis C3 der Sternschaltung 13 her.

Zudem ist zwischen der Primärseite 11/1 und der Sekundärseite 11/2 des Filtertransformators 11 ein geerdeter elektrostatischer Schirm 17 angeordnet. Die Filtereinrichtung 6, bestehend aus dem Filtertransformator 11 und der Sternschaltung 13 der Filterkondensatoren C1 bis C3, ist mit einem ersten Ausgang 31, mit einem zweiten Ausgang 32 und mit einem dritten Ausgang 33 mit einem Anpassungstransformator 8 und dieser wiederum einem zu prüfenden Transformator 15 verbunden.

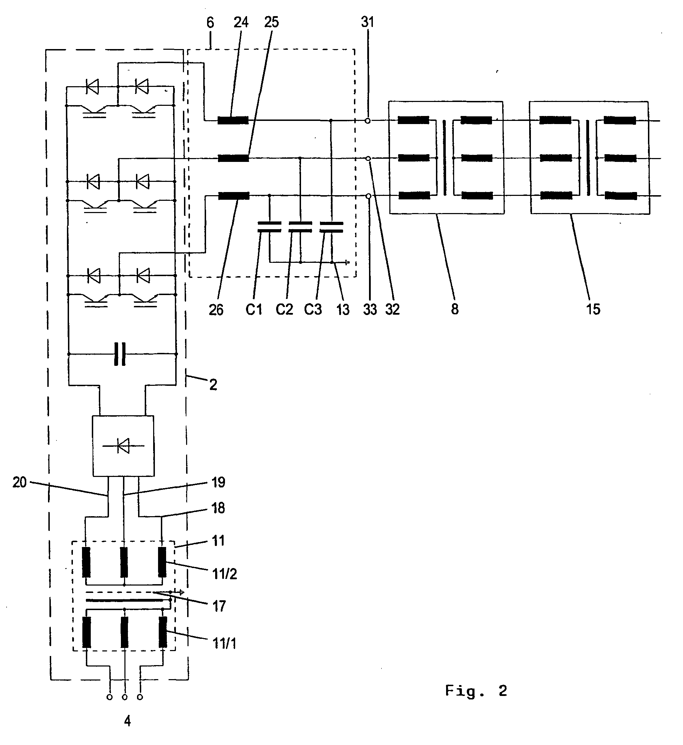

Indem nun, wie in Figur 2 dargestellt, der bisher lastseitig angeordnete Filtertransformator 11 erfindungsgemäß an die Seite des Stromnetzes 4 verlagert wird, ergeben sich deutliche Vorteile nicht nur in Bezug der auftretenden Massen der Einzelkomponenten des Prüfsystems, auch haben Versuchsaufbauten gezeigt, dass mit dem erfindungsgemäßen Prüfsystem eine bessere Unterdrückung der vom statischen Frequenzumrichter erzeugten Teilentladungsstörungen möglich ist.

Abweichend der Figur 1 ist in Figur 2 die Sekundärseite 11/2 des Filtertransformators 11 nun an den Eingängen 18, 19 und 20 des statischen Frequenzumrichters 2 angeschlossen. Dabei wird die Primärseite 11/1 des Filtertransformators 11 mit Wechselspannung aus dem Stromnetz 4 versorgt. Zwischen der Primärseite 11/1 und der Sekundärseite 11/2 ist weiterhin ein geerdeter elektrostatischer Schirm 17 vorgesehen, der zusätzlich zur Ableitung der asymmetrischen Störgrößen beiträgt. Der Filtertransformator 11 sorgt zudem für die, für eine störungsarme Teilentladungsmessung notwendige, Potenzialtrennung. Die Sekundärseite 11/2 des Filtertransformators 11 mündet, wie beschrieben, in die Eingänge 18, 19 und 20 des statischen Frequenzumrichter 2, der die erforderliche Ausgangsspannung sowie die verschiedenen benötigen Prüffrequenzen zur Verfügung stellt. Jeder der Ausgänge 21, 22 und 23 des Frequenzumrichters 2 ist innerhalb der Filtereinrichtung 6 mit einer Drossel 24, 25 und 26 verbunden und diese wiederum mit den untereinander sternförmig verschalteten und geerdeten Filterkondensatoren C1, C2 und C3. Die Ausgänge 31, 32 und 33 der Filtereinrichtung 6 sind ihrerseits an dem Anpassungstransformator 8, der seinerseits wiederum an das zu prüfende Gerät der Hochspannungstechnik, in diesem Fall einem Leistungstransformator 15, angeschlossen ist.

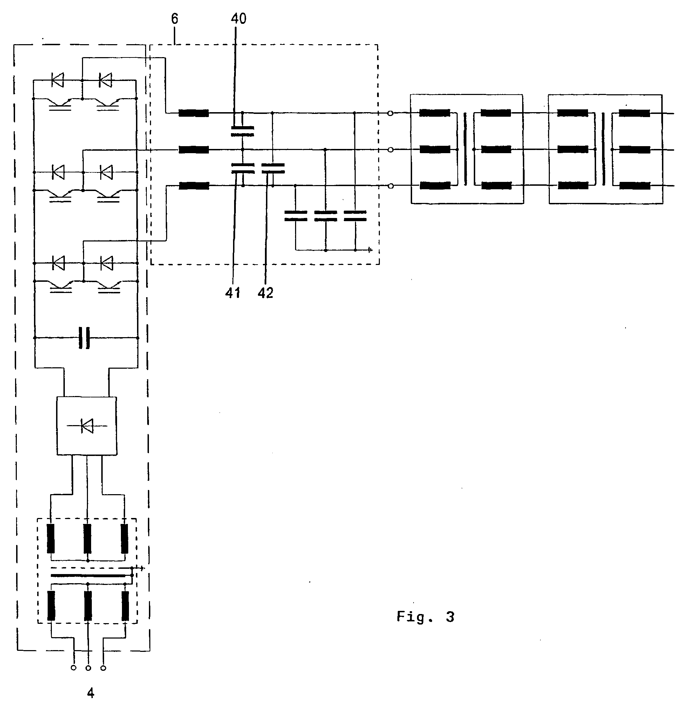

In Figur 3 sind in der Filtereinrichtung 6 zusätzlich untereinander in Dreieckschaltung verschaltete Filterkondensatoren 40, 41 und 42 vorgesehen, die eine Filterung in Bezug auf die symmetrischen Störgrößen zwischen den Außenleitern bewirken.

## Patentansprüche

1. Vorrichtung zur Hochspannungsprüfung von Geräten der Hochspannungstechnik, insbesondere von Leistungstransformatoren oder Drosseln,
aufweisend einen Filtertransformator (11), bei dem zwischen einer Primärseite (11₁) und einer Sekundärseite (11₂) ein geerdeter elektrostatischer Schirm (17) vorgesehen ist,
einen statischen Frequenzumrichter (2), der mehrere Eingänge (18, 19, 20) und Ausgänge (21, 22, 23) umfasst,
weiterhin eine Filtereinrichtung (6) aufweist, die an die Ausgänge (21, 22, 23) des Frequenzumrichters (2) angeschlossen ist,
wobei die Filtereinrichtung (6) untereinander in einer Sternschaltung mit einem geerdeten Sternpunkt (13) verschaltete Filterkondensatoren (C1, C2, C3) aufweist,
wobei die Vorrichtung einen Anpassungstransformator (8) umfasst,
wobei mehrere Ausgänge (31, 32, 33) der Filtereinrichtung (6) mit dem Anpassungstransformator (8) verbunden sind,
und der Anpassungstransformator (8) wiederum mit einem zu prüfenden Transformator (15) in Verbindung steht,
**dadurch gekennzeichnet,**
**dass** der Filtertransformator (11) an den mehreren Eingängen (18, 19, 20) des statischen Frequenzumrichters (2) angeschlossen ist, derart,
**dass** der Filtertransformator (11) eine Potenzialtrennung zwischen einem Stromnetz (4) und den Filterkondensatoren (C1, C2, C3) bewirkt und dadurch eine Teilentladungsmessung ermöglicht.

2. Vorrichtung nach Anspruch 1,
**dadurch gekennzeichnet,**
**dass** innerhalb der Filtereinrichtung (6), an den jeweiligen Ausgängen (21, 22, 23) des statischen Frequenzumrichters (2), in Reihe geschaltete Drosseln (24, 25, 26) angeordnet sind.

3. Vorrichtung nach Anspruch 1 oder,
**dadurch gekennzeichnet,**
**dass** die Filtereinrichtung (6) zusätzliche in einer Dreiecksschaltung geschaltete Filterkondensatoren (40, 41, 42) aufweist.

4. Vorrichtung nach einem der Ansprüche 1 bis 3,
**dadurch gekennzeichnet,**
**dass** der statische Frequenzumrichter (2) und der netzseitige Filtertransformator (11) zusammen mit den Drosseln 24, 25 und 26 sowie den Filterkondensatoren (C1, C2, C3) in einem Schaltschrank untergebracht sind, so dass keine asymmetrischen Störungen an den zu prüfenden Transformator (15) gelangen.

## Claims

1. Device for high-voltage testing of equipment in high-voltage technology, particularly power transformers or inductors, comprising a filter transformer (11) in which an earthed electrostatic screen (17) is provided between a primary side (11₁) and a secondary side (11₂), the screen comprising a static frequency converter (2) having several inputs (18, 19, 20) and outputs (21, 22, 23) and further comprising a filter device (6), which is connected with the outputs (21, 22, 23), wherein the filter device (6) comprises filter capacitors (C1, C2, C3) connected together in a star circuit with an earthed star point (13), wherein the device comprises a matching transformer (8), wherein a plurality of outputs (31, 32, 33) of the filter device (6) is connected with the matching transformer (8) and the matching transformer (8) is in turn connected with a transformer (15) to be tested, **characterised in that** the filter transformer (11) is so connected with the plurality of inputs (18, 19, 20) of the static frequency converter (2) that the filter transformer (11) produces a potential separation between a current mains (4) and the filter capacitors (C1, C2, C3) and thereby makes possible a partial discharge measurement.

2. Device according to claim 1, **characterised in that** choke coils (24, 25, 26) are arranged within the filter device (6) at the respective outputs (21, 22, 23) of the static frequency converter (2) and connected in series.

3. Device according to claim 1 or 2, **characterised in that** the filter device (6) additionally comprises filter capacitors (40, 41, 42) connected in a triangular circuit.

4. Device according to any one of claims 1 to 3, **characterised in that** the static frequency converter (2) and the filter transformer (11) at the power side are accommodated together with the choke coils (24, 25 and 26) and the filter capacitors (C1, C2, C3) in a switch cabinet so that no asymmetrical interferences reach the transformer (15) to be tested.

## Revendications

1. Dispositif permettant de contrôler la haute tension d'appareils relevant de la technique haute pression en particulier de transformateurs de puissance ou de bobines de choc,
comprenant un transformateur filtre (11) dans lequel il est prévu entre un côté primaire (11₁) et un côté secondaire (11₂) un écran électrostatique (17) mis à la terre,
un redresseur de fréquence statique (2) qui comporte plusieurs entrées (18, 19, 20) et plusieurs sorties (21, 22, 23), et
en outre un dispositif de filtration (6) qui est relié aux sorties (21, 22, 23) du redresseur de fréquence (2),
ce dispositif de filtration (6) comportant des condensateurs filtres (C1, C2, C3) branchés entre eux dans un circuit étoile ayant un point étoile (13) mis à la terre,
le dispositif comprenant un transformateur d'adaptation (8),
plusieurs sorties (31, 32, 33) du dispositif de filtration (6) étant reliées au transformateur d'adaptation (8), et
le transformateur d'adaptation (8) et également relié à un transformateur (15) à contrôler,
**caractérisé en ce que**
le transformateur de filtration (11) est relié aux entrées (18, 19, 20) du redresseur de fréquence statique (2) de sorte que le transformateur de filtration (11) produise une séparation de potentiel entre un réseau de courant (4) et les condensateurs filtres (C1, C2, C3) et permette ainsi une mesure de charge partielle.

2. Dispositif conforme à la revendication 1,
**caractérisé en ce que**
des bobines de choc (24, 25, 26) branchées en série sont montées à la partie interne du dispositif de filtration (6) sur les sorties respectives (21, 22, 23) du redresseur de fréquence statique (2).

3. Dispositif conforme à la revendication 1 ou 2,
**caractérisé en ce que**
le dispositif de filtration (6) comporte en outre des condensateurs filtres (40, 41, 42) branchés dans un circuit en triangle.

4. Dispositif conforme à l'une des revendications 1 à 3,
**caractérisé en ce que**
le redresseur de fréquence statique (2) et le transformateur de filtration (11) situés côté réseau sont insérés en commun avec les bobines de choc (24, 25, 26) et les condensateurs filtres (C1, C2, C3) dans une armoire de distribution de sorte qu'aucune perturbation asymétrique ne puisse parvenir au transformateur (15) à contrôler.
